# EUROPÄISCHE PATENTSCHRIFT

(11) **EP 1 614 771 B1**
(45) Veröffentlichungstag und Bekanntmachung des Hinweises auf die Patenterteilung: **13.01.2010**
(21) Anmeldenummer: 05013469.1
(22) Anmeldetag: 22.06.2005
(51) Int. Cl.: C23C 18/31, C23C 18/48, H05K 3/24

(54) **Zinnbeschichtete Leiterplatten mit geringer Neigung zur Whiskerbildung**
Tin-coated printed circuit boards with a low tendency to the whisker formation
Cartes électroniques étain-enduites avec une tendance basse à la formation de whisker

(30) Priorität: 25.06.2004 DE 102004030930
(43) Veröffentlichungstag der Anmeldung: 11.01.2006
(73) Patentinhaber: Ormecon GmbH, 22949 Ammersbek (DE)
(72) Erfinder: Wessling, Bernhard, 22941 Bargteheid (DE)
(74) Vertreter: UEXKÜLL & STOLBERG

(56) Entgegenhaltungen:
- EP-A- 1 477 587
- DE-A1- 4 238 765
- GB-A- 2 126 250
- US-A- 4 657 632
- US-A- 5 846 606
- US-A- 6 015 482
- US-A1- 2004 086 697

## Beschreibung

Die Erfindung betrifft beschichtete Artikel nach Anspruch 1.

Leiterplatten werden im allgemeinen vor ihrer Bestückung, direkt nach der Herstellung der Leiterbahnstrukturen, auf den freien Kupferflächen und in den verkupferten Bohrungen mit einer Schutzschicht versehen, die garantieren soll, daß sämtliche Lötstellen, die beim Bestücken gebildet werden sollen, sowohl elektrisch als auch mechanisch allen Anforderungen genügen. Die Schutzschichten dienen also der Absicherung der Lötfähigkeit und werden oft als "lötfähige Endoberflächen" bezeichnet.

Lötfähige Endoberflächen werden in der Industrie derzeit üblicherweise aus flüssigem Lot (Zinn-Blei- oder Silber-Zinn-Lote, sogenannte "Heißluftverzinnung") oder chemisch abgeschiedenen Nickel-Gold-, Silber-, Palladium- oder Zinnschichten dargestellt. Solche metallischen Endoberflächen sind für eine Lagerzeit von bis zu einem Jahr ausgelegt, während rein organische Endoberflächen (sogenannte "OSP"), die durch die Behandlung der Leiterplattenoberfläche mit Komplexbildnern für Kupfer erhalten werden, üblicherweise nicht länger als 3 bis 6 Monate gelagert werden können, wenn die Lötfähigkeit erhalten werden soll. Als Komplexbildner werden z.B. Imidazole, Benzimidazole, Benzotriazole, Thioharnstoff und Imidazol-2-thion eingesetzt.

Metallische Beschichtungen sind im allgemeinen für Leiterplatten gut geeignet, weisen jedoch ebenfalls eine Reihe von Nachteilen auf. Beschichtungen mit Gold sind nicht nur auf Grund des hohen Goldpreises teuer, sondern erfordern darüber hinaus spezielle Verfahren zum Aufbringen der Goldschicht. Beispielsweise kann Gold chemisch nicht in sogenannten Horizontalanlage sondern nur in Vertikalanlagen aufgebracht werden, was zusätzlich hohe Verfahrenskosten verursacht.

Das Aufbringen von Silber ist schlecht reproduzierbar, und die erforderlichen Anlagen sind schwer einzustellen.

In den letzten Jahren hat daher die chemische Verzinnung zunehmend Interesse gefunden, nicht zuletzt durch enorme Eigenschaftsverbesserungen, die aufgrund der Zinnabscheidung unter Mithilfe des Organischen Metalls Polyanilin erzielt werden konnten ("ORMECON CSN-Verfahren" der Ormecon GmbH, Ammersbek), aber auch durch verstärkte Bemühungen der Firma Atotech ("Stannatech"-Verfahren). Zinnoberflächen sind wesentlich kostengünstiger als z. B. die Beschichtung mit Ni/Au.

Aus der EP 0 807 190 B1 ist ein Verfahren zur Herstellung metallisierter Werkstoffe bekannt, bei dem der zu metallisierende Werkstoff zunächst mit einem intrinsisch leitfähigen Polymer beschichtet, das intrinsisch leitfähige Polymer dann durch Reduktion aktiviert und schließlich das Metall in nicht elektrochemischer Weise aufgebracht wird, indem der beschichtete Werkstoff mit einer Lösung von Ionen des Metalls in Kontakt gebracht wird. Das Verfahren eignet sich besonders zur Abscheidung von Zinn auf Kupfer, aber auch zur Metallisierung von Kunststoffoberflächen.

Ein Nachteil von Zinnoberflächen ist darin zu sehen, daß diese mehr oder weniger stark dazu neigen, im Verlaufe der Lagerungszeit sogenannte "Whisker" auszubilden, d.h. nadelförmige Zinnkristalle, die einige Mikrometer lang werden können und die die Funktion einer Leiterplatte stark beeinträchtigen können. Entsprechende Vorfälle vor einigen Jahren haben letztendlich dazu geführt, daß Zinnoberflächen für bestimmte Anwendungen, wie flexible Leiterplatten, "tape automated bonding" (TAB) Verfahren und "dupon film" (COF) Verfahren, und in bestimmten Regionen, wie Japan, nur schwer Akzeptanz finden.

Die Ursache der Whiskerbildung konnte bisher nicht vollständig aufgeklärt werden, jedoch ist es allgemeine Ansicht, daß mechanische Spannungen, die durch die Leiterplatte in die Kupfer- und Zinnschicht übertragen werden oder in der zinnbeschichteten Cu-Schicht entstehen, im Wege einer spannungsinduzierten Kristallisation die Nadelbildung verursachen.

Konventionelle Zinnoberflächen weisen nach einer Lagerzeit von 7 Wochen bei Raumtemperatur Whisker mit einer Länge von 30 µm bis mehr als 100 µm auf. Besonders gut läßt sich die Whiskerbildung mikroskopisch in Bohrungen mit einem Durchmesser von 0,6 bis 1,2 mm Durchmesser nachweisen. An anderen Stellen treten auch Whisker auf, die Auswertung mit dem Mikroskop fällt aber in Bohrungen leichter. Nach dem ORMECON CSN-Verfahren erzeugte Zinnoberflächen weisen nach 7 Wochen etwa 10 bis 20 µm große Whisker auf.

Die US 6,361,823 offenbart ein Verfahren, mit dem die Whiskerbildung vollständig unterbunden werden soll. Bei diesem Verfahren werden Leiterplatten zunächst mit einer Schicht aus im wesentlichem reinem Zinn versehen, auf die dann eine Legierungsschicht aus mindestens zwei Metallen aufgebracht wird. Die bevorzugten Legierungsmetalle sind Zinn und Silber. Praktische Tests haben jedoch gezeigt, daß die Whiskerbildung zwar reduziert werden konnte, jedoch nicht reproduzierbar und nicht im gewünschten Umfang.

Die Firma Unicron GmbH, Kirchheimbolanden, hat ein Verfahren entwickelt und zeitweilig vermarktet, bei dem auf den freien Kupferflächen zuerst eine Silberschicht, dann nach dem UNICRON-Verfahren (G 2) die Zinnschicht abgeschieden wird. Jedoch hat dieses Verfahren kaum Verbesserungen erbracht, einerseits, weil bei zu geringer Silberabscheidung gar kein Effekt zu erzielen war, andererseits, weil bei zu starker Silberschichtdicke (bereits ab ca 40 nm Schichtdicke) kein Zinn mehr abgeschieden wurde. Letztlich konnte mit diesem Verfahren der gewünschte Erfolg nicht erzielt werden.

Es besteht also nach wie vor ein Bedarf an der Bereitstellung von Schutzüberzügen für Leiterplatten, die keine oder nur eine geringe Neigung zur Whiskerbildung zeigen.

Diese Aufgabe wird durch beschichtete Artikel nach Anspruch 1 gelöst.

Es wurde überraschend gefunden, daß die Whiskerbildung dann wirkungsvoll unterdrückt werden kann, wenn zur Beschichtung von Leiterplatten zinnhaltige Schichten verwendet werden, die mindestens Silber als weiteres metallisches Element enthalten.

Als weitere Metalle sind solche Metallen geeignet die in Kupfer und/oder Zinn löslich sind bzw. mit Kupfer und/oder Zinn Legierungen bilden können. Vorzugsweise enthält die Schicht (iii) mindestens ein weiteres Metall, das aus Mg, Ca, Zr, Mn, Ni, Pd, Pt, Cu, Au, Zn, Ga, In, Ge, Sb, und Bi ausgewählt ist. Eine bevorzugte Gruppe von Metallen sind Ca, Zr, Mn, Ni, Pd, Pt, Au, Ga, In, Ge, Sb, und Bi. Besonders bevorzugt als weitere Metalle sind Platin, Gold, Nickel, Wismut, Kupfer und Kombinationen von zwei oder mehr dieser Metalle.

Die Schicht (iii) kann eine Legierung von Zinn und dem oder den weiteren Metallen enthalten. Gemäß einer alternativen Ausführungsform enthält die Schicht (iii) eine feinteilige oder mehrphasige Mischung von Zinn und dem oder den weiteren Metallen. im letztgenannten Fall haben die Metallpartikel oder die Metallphasen vorzugsweise eine Größe von 1 bis 500 nm.

Wenn im folgenden der Begriff "Legierung" verwendet wird, so werden darunter sowohl Legierungen im engeren Sinne (also Mischungen von Metallen auf atomarer Ebene) als auch feinteilige oder mehrphasige Mischungen verstanden. Feinteilige Mischungen stellen Dispersionen eines oder mehrerer Metalle in feinteiliger Form in einer Matrix eines anderen Metalls dar.

Die Schicht (iii) enthält zusätzlich zumindest die elektrisch leitfähiges Polymer.

Als weitere organische Additive eignen sich besonders Komplexbildner.

Bevorzugt sind Komplexbildner, die zur Komplexbildung mit Kupfer fähig sind, insbesondere Thioharnstoff, Imidazole, Benzimidazole, Benzotriazole, Harnstoff, Zitronensäure, Imidazol-Thione und Mischungen davon.

Das elektrisch leitfähige Polymer liegt vorzugsweise in Form eines Organischen Metalls vor. Kombinationen verschiedener Stoffe aus dieser Stoffklasse können verwendet werden. Unter Polymeren werden im Rahmen dieser Erfindung, wenn nicht anders angegeben, organische Polymere verstanden.

Unter elektrisch leitfähigen Polymeren oder leitfähigen Polymeren, die auch "intrinsisch leitfähige Polymere" genannt werden, werden Stoffe verstanden, die aus niedermolekularen Verbindungen (Monomeren) aufgebaut sind, durch Polymerisation mindestens oligomer sind, also mindestens 3 Monomereinheiten enthalten, die durch chemische Bindung verknüpft sind, im neutralen (nicht leitfähigen) Zustand ein konjugiertes π-Elektronensystem aufweisen und durch Oxidation, Reduktion oder Protonierung (was oftmals als "dotieren" bezeichnet wird) in eine ionische Form überführt werden können, die leitfähig ist. Die Leitfähigkeit beträgt mindestens 10⁻⁷ S/cm und liegt üblicherweise unter 10⁵ S/cm.

Als Dotierungsmittel werden im Falle der Dotierung durch Oxidation z.B. Jod, Peroxide, Lewis- und Protonensäuren oder im Falle der Dotierung durch Reduktion z.B. Natrium, Kalium, Calcium eingesetzt.

Leitfähige Polymere können chemisch außerordentlich unterschiedlich zusammengesetzt sein. Als Monomere haben sich z.B. Acetylen, Benzol, Napthalin, Pyrrol, Anilin, Thiophen, Phenylensulfid, peri-Naphthalin und andere, sowie deren Derivate, wie Sulfo-Anilin, Ethylendioxythiophen, Thieno-thiophen und andere, sowie deren Alkyl- oder Alkoxy-Derivate oder Derivate mit anderen Seitengruppen, wie Sulfonat-, Phenyl- und andere Seitengruppen, bewährt. Es können auch Kombinationen der oben genannten Monomere als Monomer eingesetzt werden. Dabei werden z.B. Anilin und Phenylensulfid verknüpft und diese A-B-Dimere dann als Monomere eingesetzt. Je nach Zielsetzung können z.B. Pyrrol, Thiophen oder Alkylthiophene, Ethylendioxythiophen, Thieno-thiophen, Anilin, Phenylensulfid und andere miteinander zu A-B-Strukturen verbunden und diese dann zu Oligomeren oder Polymeren umgesetzt werden.

Die meisten leitfähigen Polymere weisen einen mehr oder weniger starken Anstieg der Leitfähigkeit mit steigender Temperatur auf, was sie als nicht-metallische Leiter ausweist. Andere leitfähige Polymere zeigen zumindest in einem Temperaturbereich nahe Raumtemperatur ein metallisches Verhalten insofern, als die Leitfähigkeit mit steigender Temperatur sinkt. Eine weitere Methode, metallisches Verhalten zu erkennen, besteht in der Auftragung der sogenannten "reduzierten Aktivierungsenergie" der Leitfähigkeit gegen die Temperatur bei niedrigen Temperaturen (bis nahe 0 K). Leiter mit einem metallischen Beitrag zur Leitfähigkeit zeigen eine positive Steigung der Kurve bei niedriger Temperatur. Solche Stoffe bezeichnet man als "organische Metalle".

Organische Metalle sind an sich bekannt. Gemäß Weßling et al., Eur. Phys. J. E 2, 2000, 207-210, kann der Übergang vom Zustand eines nicht-metallischen zu einem zumindest teilweise metallischen Leiter durch einen einstufigen Reib- bzw. Dispersionsvorgang nach vollendeter Synthese des intrinsisch leitfähigen Polymers bewirkt werden, dessen verfahrenstechnische Grundlage in der EP 0 700 573 A beschrieben wird. Hierbei wird durch den Dispersionsvorgang auch die Leitfähigkeit erhöht, ohne daß die chemische Zusammensetzung des verwendeten leitfähigen Polymeren wesentlich verändert wird.

Bevorzugte intrinsisch leitfähige Polymere sind die oben genannten. Insbesondere können als Beispiele genannt werden: Polyanilin (PAni), Polythiophen (PTh), Poly(3,4-ethylendioxythiophene) (PEDT), Polydiacetylen, Polyacetylen (PAc), Polypyrrol (PPy), Polyisothianaphthen (PITN), Polyheteroarylenvinylen (PArV), wobei die Heteroarylen-Gruppe z.B. Thiophen, Furan oder Pyrrol sein kann, Poly-p-phenylen (PpP), Polyphenylensulfid (PPS), Polyperinaphthalin (PPN), Polyphthalocyanin (PPc) u.a., sowie deren Derivate (die z.B. aus mit Seitenketten oder -gruppen substituierten Monomeren gebildet werden), deren Copolymere und deren physikalische Mischungen. Besonders bevorzugt sind Polyanilin (PAni), Polythiophen (PTh), Polypyrrol (PPy) und deren Derivate sowie Mischungen davon. Am meisten bevorzugt ist Polyanilin.

Mischungen aus Komplexbildnern und elektrisch leitfähigen Polymeren sind ebenfalls geeignet.

Das oder die organischen Additive werden vorzugsweise in einer Menge von 1 ppb bis 5 Gew.-% bezogen auf die Gesamtmasse der Schicht (iii) eingesetzt.

Als Basisschicht (i) sind alle in der Leiterplattentechnik eingesetzten Materialien geeignet, insbesondere Epoxide und Epoxidcomposite, Teflon, Cyanatester, Keramik, Cellulose und Cellulosecomposite, wie beispielsweise Pappe, auf diesen Stoffen basierende Materialien sowie flexible Basisschichten z.B. auf Basis von Polyimid. Die Basisschicht weist vorzugsweise eine Schichtdicke von 0,1 bis 3 mm auf.

Die Kupferschicht oder Kupferlegierungsschicht (ii) hat vorzugsweise eine Dicke von 5 bis 210 µm, insbesondere 15 bis 35 µm.

Die Schicht (iii) weist vorzugsweise eine Schichtdicke von 50 nm bis 4 µm, besonders bevorzugt 100 nm bis 3,5 µm, ganz besonders bevorzugt 200 nm bis 3 µm und insbesondere 200 nm bis 2 µm auf.

Das oder die weiteren Metalle sind nicht homogen in der Schicht (iii) verteilt, d.h. daß die Konzentration des weiteren Metalls über die Dicke der Schicht (iii) variiert.

Bis zu der Tiefe, bei der die Zinnkonzentration in der Schicht (iii) mehr als 50 Mol-% beträgt, liegt das Silber und gegebenenfalls die weiteren Metalle vorzugsweise in einer Konzentration von mehr als 100 ppm und weniger als 50 Mol-% vor. Besonders bevorzugt sind Schichten (iii), bei denen die Zinnkonzentration in den äußeren 300 nm bis 3 µm der Schicht (iii) mehr als 50 Mol-% beträgt.

Die Konzentration des Silbers und der gegebenenfalls weiteren Metalle ist vorzugsweise wie folgt gestaffelt. In den äußeren 0,5 bis 5% der Schicht ist die Konzentration dieser weiteren Metalle niedriger als in den nachfolgenden 2 bis 10% der Schicht, und dort höher als in den darunterliegenden 5 bis 95 % der Schicht. Die Prozentangaben beziehen sich auf die Schichtdicke.

Die erfindungsgemäßen Artikel eignen sich besonders zur Herstellung von Leiterplatten, vorzugsweise handelt es sich bei den Artikeln um Leiterplatten, die auch als Platinen bezeichnet werden. Hierbei handelt es sich um der Montage elektrischer Bauelemente dienende, dünne Platten, die Löcher aufweisen können. Die Löcher dienen beispielsweise zur Verbindung von Ober- und Unterseite der Platten, zur Verfügungstellung von Lot oder zur Aufnahme der Anschlüsse von Bauelementen zur weiteren Verlötung.

Zur Herstellung der erfindungsgemäßen beschichteten Artikel und insbesondere von Leiterplatten wird das Verfahren gemäß Anspruch 14 verwendet.

Gemäß einer bevorzugten Ausführungsform des Verfahrens wird die Kupfer- oder Kupferlegierungsschicht (ii) im Anschluß an Schritt (1) entfettet und gereinigt. Hierzu werden die Artikel vorzugsweise mit handelsüblichen, sauren oder basischen Reiniger behandelt. Bevorzugt sind Reiniger auf der Basis von Schwefelsäure und Zitronensäure, wie z.B. der Reiniger ACL 7001 der Ormecon GmbH. Die Artikel werden vorzugsweise für etwa 2 Minuten bei 45 °C in dem Reinigungsbad belassen und anschließend mit Wasser gewaschen.

Außerdem ist es bevorzugt, die Kupfer- oder Kupferlegierungsschicht (ii) im Anschluß an Schritt (1) oder nach der Reinigung oxidativ vorzubehandeln, beispielsweise durch Ätzen der Oberfläche mit H₂O₂ oder anorganischen Peroxiden. Geeignete Ätzlösungen sind kommerziell erhältlich, wie beispielsweise die wasserstoffperoxidhaltige Lösung Etch 7000 der Ormecon GmbH. Die Artikel werden vorzugsweise für etwa 2 Minuten bei 30 °C in der Ätzlösung belassen.

Die in Schritt (1) hergestellte Schicht wird vorzugsweise mit lithographischen oder Ätzprozessen strukturiert, womit die Leiterbahnstruktur erzeugt wird. Die Schritte (1) und (2) können heute auch durch das direkte Aufbringen einer strukturierten Cu-Leiterbahn oder ähnliche Verfahren ersetzt werden.

Im Anschluß an Schritt (2) werden ggf. Bohrungen ("Löcher") erzeugt, die anschließend verkupfert werden.

Die Durchführung der einzelnen Schritte des obigen Verfahrens ist dem Fachmann an sich bekannt.

In Schritt (3) bringt man die zinnhaltige Schicht vorzugsweise dadurch auf, daß man Zinn und das weitere Metall aus einem Bad, das Zinnionen und Ionen des oder der weiteren Metalle enthält, chemisch durch Komplexbildung und Redoxprozesse auf der in Schritt (2) gebildeten Schicht abscheidet.

Besonders bevorzugt ist ein Verfahren bei dem man das Zinn und das oder die weiteren Metalle aus zwei oder mehr unterschiedlichen Bädern, die Zinnionen und/oder Ionen des weiteren Metalls enthalten, chemisch durch Komplexbildung und Redoxprozesse auf der in Schritt (2) gebildeten Schicht abscheidet. Diese Verfahrensvariante ermöglicht es, separate Bäder für die einzelnen Metalle und gegebenenfalls Additive einzusetzen. Auf diese Weise läßt sich die Abscheidungsrate der einzelnen Metalle und Additive gezielt steuern, so daß sich deren Konzentration in der Schicht (iii) reproduzierbar und mit relativ geringem Kontrollaufwand einstellen läßt.

Überraschend wurde gefunden, daß Schicht (iii) in einfacher Weise erzeugt werden kann, indem man zuerst eine Schicht des Silbers und gegenbenenfalls des weiteren Metalls und der elektrisch leitfähigen Polymers auf der in Schritt (2) gebildeten Schicht abscheidet und man dann auf dieser Schicht eine Zinnschicht abscheidet.

Vorzugsweise wird zusätlich zu Silber als weiteres Metall zunächst ein Metall aus der Gruppe Mg, Ca, Zr, Mn, Ni, Pd, Pt, Cu, Ag, Au, Zn, Ga, In, Ge, Sb, und Bi aufgebracht, wobei es besonders bevorzugt ist, dies in Gegenwart der oben genannten organischer Additive zu tun. Als weitere Metalle sind Platin, Gold, Nickel, Wismut, Kupfer bevorzugt. Danach wird eine Zinnschicht mit einem konventionellen Zinnbad aufgebracht, wobei das Zinnbad ebenfalls ein oder mehrere organische Additive enthalten kann. Vorzugsweise werden das oder die weiteren Metalle zusammen mit einem leitfähigem Polymer und das Zinn zusammen mit einem Kupferkomplexbildner abgeschieden.

Die Schicht des Silbers und des elektrisch leitfähigen Polymers wird vorzugsweise in einer Dicke von 3 bis 100 nm, vorzugsweise 10 bis 40 nm und ganz besonders bevorzugt 10 bis 20 nm abgeschieden.

Zum Beispiel wird in einer bevorzugten Ausführungsform die Kupferoberfläche zuerst entfettet und oxidativ geätzt, und dann mit einem Bad behandelt, das Ag-Kationen in gelöster und Polyanilin in kolloid-disperser Form enthält; es wird die Silber und organische Komponenten enthaltende Schicht in einer Dicke von 3 bis 100 nm abgeschieden. Daraufhin wird Zinn aus einem Zinn(II)-Kationen und Thioharnstoff oder einen anderen Komplexbildner enthaltenden sauren Bad abgeschieden.

Das Zinn wird in einer solchen Menge abgeschieden, daß die gewünschte Schichtdicke erreicht wird, vorzugsweise in einer Schichtdicke von 100 nm bis 3 µm.

Das oder die weiteren Metalle und gegebenenfalls das oder die organischen Additive werden vorzugsweise aus einem oder mehreren wäßrigen Bäder abgeschieden, die Ionen des oder der jeweiligen Metalle in einer Konzentration von jeweils 0,003 bis 1 Gew.-% und gegebenenfalls ein oder mehrere organische Additive in einer Konzentration von jeweils 0,001 bis 25 Gew.-% enthalten. Wenn das Bad als organisches Additiv einen Kupferkomplexbildner enthält, wird dieser vorzugsweise in einer Konzentration von 0,1 bis 5 Gew.-% verwendet. Elektrisch leitfähige Polymere werden vorzugsweise in einer Badkonzentration von 0,001 bis 0,1 Gew.-% eingesetzt. Vorzugsweise werden als kupferkomplexbildende Additive Thioharnstoff, Imidazole, Benzimidazole, Benzotriazole oder verwandte Verbindungen wie Imidazol-Thione und Mischungen davon verwendet.

Das erfindungsgemäße Verfahren führt überraschenderweise nicht zur Ausbildung einer dichten Schicht des oder der weiteren Metalle auf der Oberfläche des Artikels. Vielmehr wird eine offenporige, poröse Oberfläche erhalten, die auch als membranartig, schwamm- oder moosartig bezeichnet werden kann. Untersuchungen haben gezeigt, daß vermutlich eine dichte Ag-Schicht die Ursache dafür ist, daß das Zinn nur noch sehr langsam oder gar nicht mehr abgeschieden wird, während eine offenporige Ag-Schicht die anschließende Bildung der Zinnschicht nicht behindert.

Im Gegensatz zu herkömmlichen Verfahren ergibt das anschließende Abscheiden des Zinns keine reine Zinnschicht, die an der Grenzfläche zur Kupferschicht intermetallische Sn-Cu-Phasen ausbildet, sondern es wurde überraschend gefunden, daß das erfindungsgemäße Verfahren zur Ausbildung einer Zinnlegierung, führt, die knapp unterhalb der äußeren Oberfläche eine relativ hohe Konzentration des Silbers oder gegebenenfalls der weiteren Metalle aufweist. Überraschend ist auch, daß die Konzentration des Silbers und gegebenenfalls der weiteren Metalle an der Kupferoberfläche, also dort, wo diese Metalle ursprünglich abgeschieden wurden, niedriger als in der darüberliegenden Teilschicht der Schicht (iii) ist und nicht höher, wie eigentlich anzunehmen gewesen wäre. Diese Metalle sind bis in die zinnarmen Regionen hinein nachweisbar, und die Konzentration dieser Metalle ändert sich von der äußeren Oberfläche, wo knapp unterhalb der Oberfläche das Maximum der Konzentration vorliegt, obwohl die elektrisch leitfähige Polymere enthaltende Silberschicht als erste auf Kupfer aufgebracht wird, bis in die ersten kupferreichen Schichten hinein vorzugsweise nur um eine Zehnerpotenz.

Die Schicht (iii) enthält gemäß einer besonders bevorzugten Ausführungsform als weitere Metalle Silber und Kupfer, wobei sowohl das Silber als auch das Kupfer zu nennenswerten Mengen an der äußeren Oberfläche der Schicht (iii) zu finden sind.

Es wurde auch beobachtet, daß das erfindungsgemäße Verfahren zur Ausbildung von intermetallischen Sn-Cu-Phasen an der Grenzfläche zu Kupfer führt, die breiter und die Phasengrenzen weniger scharf sind wie bei herkömmlichen Verfahren gebildeten Sn-Cu-Phasen.

Das erfindungsgemäße Verfahren ergibt überraschenderweise nicht den zu erwartenden, definierten Schichtaufbau der Form Sn-Schicht/Ag-Schicht/Cu-Schicht, gegebenenfalls unter Ausbildung intermetallische Phasen, sondern eine Zinnschicht, die an der Oberfläche eine relativ hohe Konzentration an Ag aufweist, die unerwarteter Weise höher als in tieferen Schichten ausfällt. Auch weist die Schicht (iii) eine relativ hohe Cu-Konzentration in den äußeren Teilschicht auf, ebenso wie eine relativ hohe Sn-Konzentration in den inneren kupferreichen Schichten.

Eine mindestens ebenso grundlegende Überraschung besteht darin, daß die erfindungsgemäß hergestellten, zinnhaltigen Schichten (iii) in wesentlich geringerem Umfang zur Whiskerbildung neigen als bekannte Schichten. Darüber hinaus behalten die Schichten ihre Lötfähigkeit über lange Zeiträume bei. Die Schicht (iii) enthält nur wenige und vorzugsweise keine Whisker mit einer Länge von mehr als 10 µm und ist besonders bevorzugt selbst nach 14wöchiger Lagerung bei Raumtemperatur noch frei von Whiskern (bestimmt durch lichtmikroskopische Betrachtung). Eine Erklärung für den Erfolg gibt es derzeit nicht. Es wird vermutet, daß der oben beschriebene Aufbau der Schicht (iii) die Übertragung der Spannungen dämpft, die zur Whiskerbildung führen.

Im Folgenden wird die Erfindung anhand von Ausführungsbeispielen und Figuren in nicht einschränkender Weise näher erläutert, wobei
Figur 1 ein Sekundärionen-Massenspektrum der Schicht (iii) einer erfindungsgemäßen Leiterplatte zeigt,
Figur 2 ein Sekundärionen-Massenspektrum einer mit herkömmlichen Verfahren erzeugten Schicht (iii) einer Leiterplatte zeigt,
Figur 3 ein Sekundärionen-Massenspektrum einer erfindungsgemäß geeigneten Silberschicht auf einer Leiterplatte zeigt,
Figur 4 eine elektronenmikroskopische Aufnahme einer erfindungsgemäß geeigneten Silberschicht auf einer Leiterplatte zeigt,
Figur 5 ein Sekundärionen-Massenspektrum einer erfindungsgemäß nicht geeigneten Silberschicht auf einer Leiterplatte zeigt,
Figur 6 eine lichtmikroskopische Aufnahme einer 1 mm Bohrung in einer erfindungsgemäß beschichteten Leiterplatte zeigt,
Figur 7 eine lichtmikroskopische Aufnahme einer 1 mm Bohrung in einer nicht erfindungsgemäß beschichteten Leiterplatte zeigt, und
Figur 8 eine lichtmikroskopische Aufnahme einer 1 mm Bohrung in einer weiteren nicht erfindungsgemäß beschichteten Leiterplatte zeigt.

### Ausführungsbeispiele

### Beispiel 1: Herstellung beschichteter Leiterplatten

Leiterplatten aus Epoxidharz-Composite wurden unter Verwendung eines handelsüblichen Reinigers auf der Basis von Schwefelsäure und Zitronensäure (ACL 7001, Ormecon GmbH) in einem Reinigungsbad für 2 Minuten bei 45 °C gereinigt und entfettet. Die verwendeten Leiterplatten hatten ein Testdesign, das mit Prüfinstituten und Leiterplattenherstellern abgestimmt und realen Leiterplattenstrukturen nachempfunden ist. Diese Platten erlauben die Messung und Beurteilung der Lötfähigkeit. Anschließend wurden die Leiterplatten bei Raumtemperatur mit Leitungswasser gespült und danach für 2 Minuten bei 30 °C mit einer H₂O₂ enthaltenden Ätzlösung (Etch 7000, Ormecon GmbH) behandelt. Nach dem Ätzen wurden die Platten erneut bei Raumtemperatur mit Leitungswasser gespült. Nach dem Spülen wurden die Leiterplatten für 45 sec in eine 40 °C warme wäßrige Lösung bzw. Dispersion, die Thioharnstoff (30 g/l), Schwefelsäure (20 g/l), 200 mg / l Silber als Silbersulfat und 1 g / l einer 4%igen wäßrigen Dispersion von Polyanilin enthielt, getaucht. Es schied sich eine gleichmäßig silbrig-durchscheinende Schicht ab. Anschließend wurden die Leiterplatten auf herkömmliche Weise mit eine Sn²⁺-haltigem Bad verzinnt.

Die vor der Verzinnung mittels Röntgenfluoreszenz-Spektroskopie gemessene Dicke der Silberschicht betrug 10 nm, während eine Schichtdicke von 40 nm resultierte, wenn man elektrochemische Meßmethoden verwendete (Galvanocoulometrie). Die Erklärung für diese Abweichung liegt in der organischen Komponente der Schicht.

Die Leiterplatten wurden mittels Sekundärionen-Massenspektroskopie (SIMS) untersucht. Bei dieser Untersuchungsmethode wird die Schicht schichtweise abgetragen und analysiert. Geringe Sputterzeiten entsprechen den äußeren Bereichen der Schicht, währen bei längeren Sputterzeiten tiefere Bereiche der Schicht dargestellt werden. Eine Sputterzeit von 500 s entspricht hier in etwa einer Schichtdicke von 800 nm, d.h. nach 500 s sind die oberen 800 nm der Schicht abgetragen.

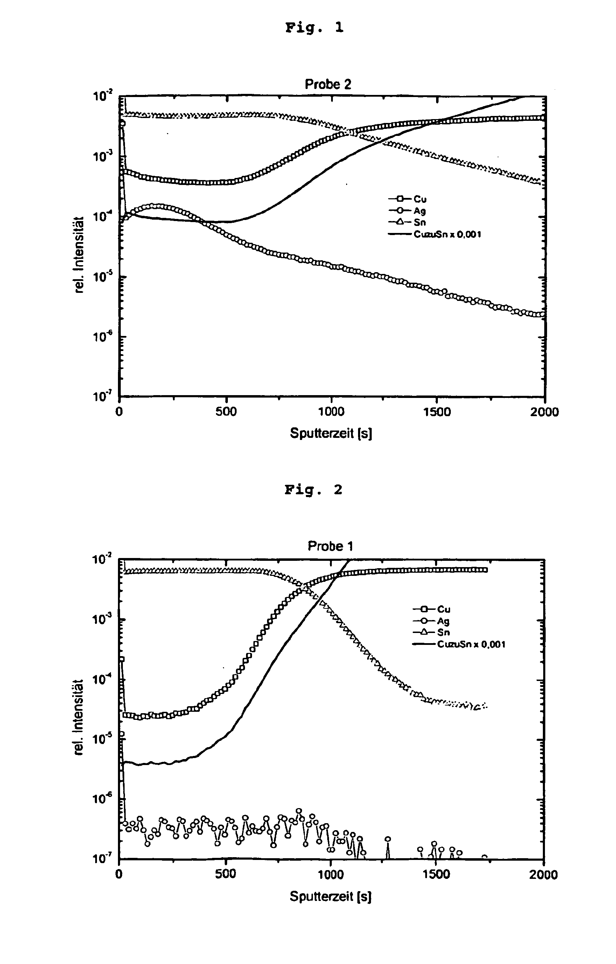

Figur 1 zeigt das SIMS-Spektrum der Schicht (iii) nach der Verzinnung. Es ist deutlich zu sehen, daß das Silber über den gesamten untersuchten Schichtbereich hinweg verteilt vorkommt und überraschenderweise an der Oberfläche (Sputterzeit 0 bis 500 s) eine um ein bis zwei Größenordnungen höhere Konzentration aufweist als im Inneren der Schicht, obwohl das Silber vor der Verzinnung aufgebracht wurde. Ebenso ist deutlich zu sehen, daß die Zinn- und Kupfer-Konzentrationen gleichmäßig über die Schichtdicke abfallen. Die Kurve "CuzuSn" gibt das Verhältnis von Kupfer zu Zinn an. Dieses erreicht nach einer Sputterzeit von etwa 1900 s (entspricht etwa 3 µm) einen Wert von 10⁻⁴. Das Spektrum belegt die Ausbildung einer Legierung bzw. einer feinteiligen Mischung der Metalle.

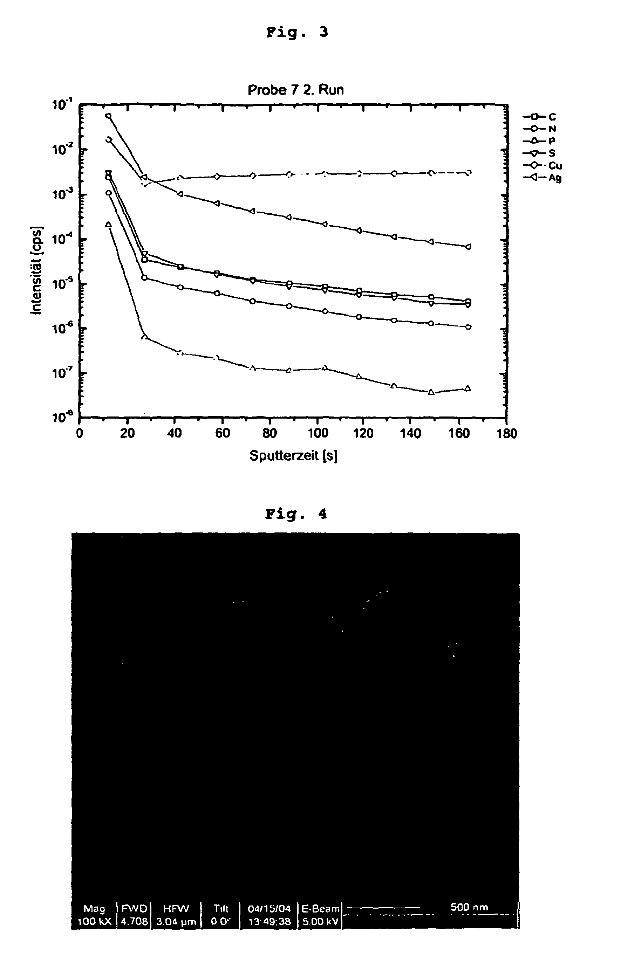

Figur 3 zeigt ein mittels Sekundärionen-Massenspektroskopie aufgenommene Spektrum der Silberschicht vor der Verzinnung. Das Spektrum zeigt, daß die Schicht neben Silber und Kupfer nennenswerte Mengen der Elemente C, N, P und S enthält, die aus den eingesetzten organischen Additiven stammen.

In Figur 4 ist eine elektronenmikroskopische Aufnahme der Silberschicht zu sehen. Es ist deutlich die offenporinge, poröse Struktur der Schicht zu erkennen.

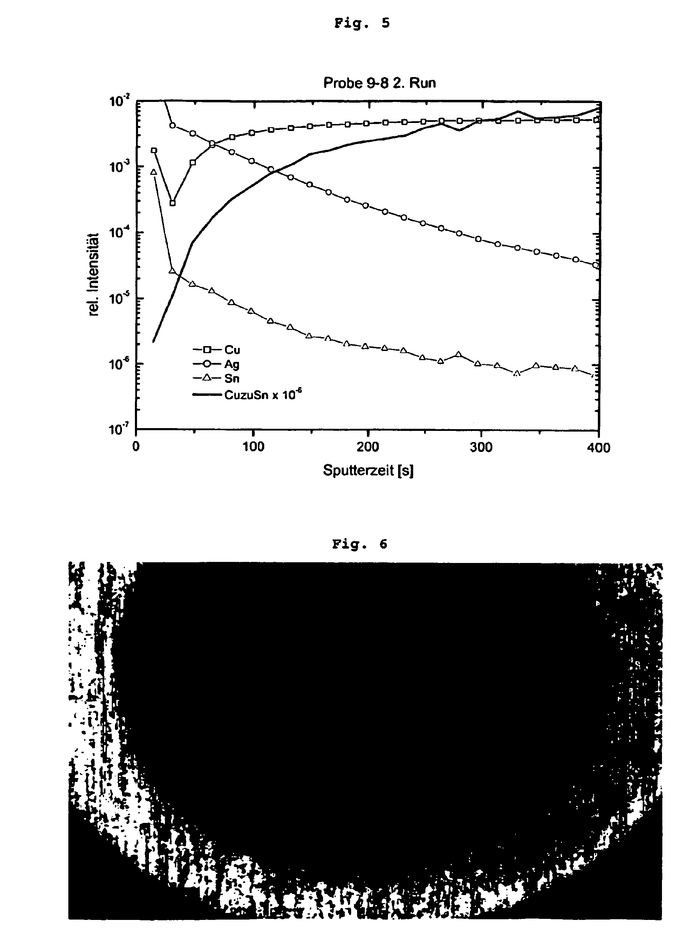

Im Vergleich dazu zeigt Figur 5 das SIMS-Spektrum einer Silberschicht, die bei höherer Silberkonzentration, höherer Temperatur und längerer Verweilzeit der Leiterplatte im Silberbad erhalten wurde. Die Silberschicht ist deutlich dicker und dichter als die in Figur 3 gezeigte Schicht, so daß darauf kaum noch Zinn abgeschieden werden kann.

### Beispiele 2 bis 7: Herstellung beschichteter Leiterplatten (Vergleich)

Analog zu den Beispiel 1 wurden Leiterplatten gemäß den jeweiligen Anwendungsvorschriften mit handelsüblichen Mittel verzinnt.

Es wurden die Produkte ORMECON CSN (Ormecon GmbH, Ammersbek; Beispiel 2), ORMECON CSN FF (Ormecon GmbH, Ammersbek; Beispiel 3), Shipley Tinposit LT 34 (Beispiel 4), Unicron G 2 (Unicron GmbH, Kirchheimbolanden; Beispiel 5), OMIKRON (Fa. Cirtech, Florida, USA; Beispiel 6) und Stannatech (Fa. Atotech, Berlin; Beispiel 7) verwendet.

Figur 2 zeigt das Sekundärionen-Massenspektrum der Leiterplatte aus Vergleichsbeispiel 3. Ein Vergleich mit Figur 1 läßt deutlich erkennen, daß die Zinn- und Kupfer-Konzentrationen sprunghafte Verläufe zeigen, d.h. die Zinnschicht fällt bei einer Sputterzeit von etwa 900 s sprunghaft ab während die Kupferkonzentration gleichzeitig sprunghaft ansteigt. Dies läßt auf ein weitgehende Trennung der Schichten schließen. Das Kupfer zu Zinnverhältnis von 10⁻⁴ wird hier schon nach einer sehr viel kürzeren Sputterzeit erreicht.

### Beispiel 8: Bestimmung der Whiskergröße

Die in den Beispielen 1 bis 7 hergestellten Leiterplatten wurden für 7 und 14 Wochen bei Raumtemperatur gelagert. Anschließend wurden die Platten lichtmikroskopisch auf die Bildung von Whiskern untersucht und gegebenenfalls die Größe der Whisker bestimmt. Hierzu wurden Bohrungen von 1 mm Durchmesser betrachtet, da hier Whisker aufgrund des dunklen Hintergrundes leichter nachweisbar waren. Die Ergebnisse sind in der folgenden Tabelle 1 zusammengestellt.

**Tabelle 1**

| **Bestimmung der Whiskergröße** | | |
|---|---|---|
| **Beispiel** | **Lagerzeit 7 Wochen Größe der Whisker** | **Lagerzeit 14 Wochen Größe der Whisker** |
| **1** | keine Whisker | keine Whisker |
| **2*** | 10 - 20 µm | -¹⁾ |
| **3*** | 20 - 30 µm | -¹⁾ |
| **4*** | > 100 µm | -¹⁾ |
| **5*** | > 100 µm | -¹⁾ |
| **6*** | 20 - 30 µm | -¹⁾ |
| **7*** | 20 - 30 µm | -¹⁾ |

| | | |
|---|---|---|
| * Vergleichsbeispiel ¹⁾ nicht gemessen | | |

Figur 6 zeigt eine lichtmikroskopische Aufnahme einer Leiterplatte aus Beispiel 1 nach 14wöchiger Lagerung. Es ist keine Whiskerbildung zu erkennen.

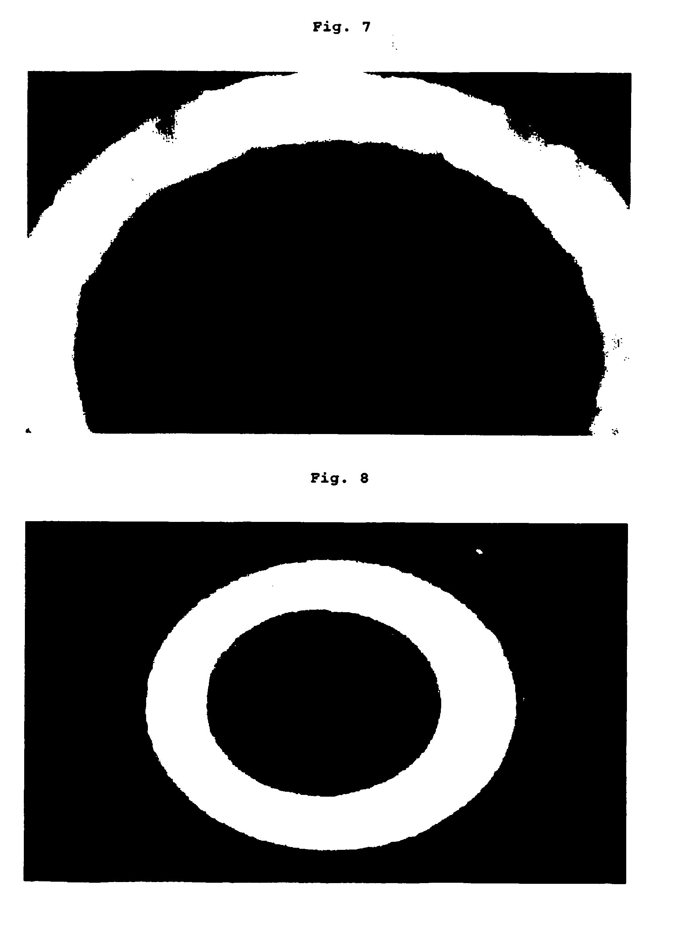

In Figur 7 ist eine lichtmikroskopische Aufnahme der Leiterplatte aus Vergleichsbeispiel 3 nach 7wöchiger Lagerung gezeigt. Die Aufnahme ist auf eine Whiskerfaser im oberen Bereich der Bohrung (bei 12 Uhr) fokussiert.

In Figur 8 ist eine Aufnahme einer Leiterplatte gemäß Vergleichsbeispiel 4 nach 7wöchiger Lagerung gezeigt. Hier sind in der Fokussierebene eine Vielzahl von Whiskern zu erkennen.

## Patentansprüche

1. Beschichteter Artikel, der
(i) mindestens eine nicht elektrisch leitende Basisschicht,
(ii) mindestens eine Schicht aus Kupfer und/oder einer Kupferlegierung, und
(iii) eine zinnhaltige Schicht enthält,
wobei die Schicht (ii) zwischen der Schicht (i) und der Schicht (iii) angeordnet ist, **dadurch gekennzeichnet, daß** die zinnhaltige Schicht (iii) mindestens Silber als weiteres Metall und mindestens ein elektrisch leitfähiges Polymer enthält, wobei die Konzentration des Silbers an der Kupfergrenzfläche niedriger ist als in der darüber liegenden Teilschicht der Schicht (iii).

2. Beschichteter Artikel nach Anspruch 1 bei dem die Schicht (iii) eine feinteilige oder mehrphasige Mischung von Zinn und Silber enthält.

3. Beschichteter Artikel nach Anspruch 2, bei dem die Metallpartikel oder die Metallphasen eine Größe von 1 bis 500 nm aufweisen.

4. Beschichteter Artikel nach einem der Ansprüche 1 bis 3, bei dem die Schicht (iii) zusätzlich einen Komplexbildner enthält.

5. Beschichteter Artikel nach Anspruch 4, bei dem der komplexbilder zur Komplexbildung mit Kupfer fähig ist.

6. Beschichteter Artikel nach Anspruch 1, bei dem das das elektrisch leitfähige Polymer aus der Gruppe der Polyaniline, Polythiophene, Polypyrrole, und Mischungen davon ausgewählt ist.

7. Beschichteter Artikel nach einem der Ansprüche 1 bis 6, bei dem die Schicht (iii) 1 ppb bis 5 Gew.-% elektrisch litfähiges Polymer enthält.

8. Beschichteter Artikel nach einem der vorangehenden Ansprüche, bei dem die Schicht (i) eine Schichtdicke von 0,1 bis 3 mm aufweist.

9. Beschichteter Artikel nach einem der vorangehenden Ansprüchen, bei dem die Schicht (ii) eine Schichtdicke von 5 bis 210 µm aufweist.

10. Beschichteter Artikel nach einem der vorangehenden Ansprüche, bei dem die Schicht (iii) eine Schichtdicke von 50 nm bis 4 µm aufweist.

11. Beschichteter Artikel nach einem der vorhergehenden Ansprüche, bei dem die Zinnkonzentration in den äußeren 300 nm bis 3 µm der Schicht (iii) mehr als 50 Mol-% beträgt.

12. Beschichteter Artikel nach einem der vorhergehenden Ansprüche, bei dem die Konzentration des Silbers in den oberen 0,5 bis 5% der Schicht (iii) niedriger als in den nachfolgenden 2 bis 10%, und dort höher ist als in den darunterliegenden 5 bis 95 % der Schicht ist.

13. Beschichteter Artikel nach einem der vorhergehenden Ansprüche in Form einer Leiterplatte.

14. Verfahren zur Herstellung eines beschichteten Artikels gemäß den Ansprüchen 1 bis 13, bei dem
(1) man auf die Oberfläche einer Basisschicht eine Schicht aus Kupfer oder einer kupferhaltigen Legierung aufbringt,
(2) man die in Schritt (1) hergestellte Schicht strukturiert; und
(3) man auf die strukturierte Kupfer- oder Kupferlegierungsschicht eine zinnhaltige Schicht aufbringt, wobei man zuerst eine Schicht von Silbers als weiteres Metall und ein elektrisch leitfähiges Polymer auf der in Schritt (2) gebildeten Schicht abscheidet wobei eine offenporinge, poröse Oberfläche entsteht, und man dann auf der Schicht des Silbers und des leitfähiges Polymers eine Zinnschicht abscheidet.

15. Verfahren nach Anspruch 14, bei dem man die Schicht des Silbers und des leitfähigen Polymers in einer Dicke von 3 bis 100 nm abscheidet.

16. Verfahren nach Anspruch 14 oder 15, bei dem man das Zinn in einer Schichtdicke von 100 nm bis 3 µm abscheidet.

17. Verfahren nach einem der Ansprüche 14 bis 15, bei dem man die Schicht des Silbers und des leitfähigen Polymers aus einem wäßrigen Bad abscheidet, das Ionen des Metalls in einer Konzentration von 0,003 bis 1 Gew.-% und ein oder mehrere organische Additive in einer Konzentration von jeweils 0,001 bis 25 Gew.-% enthält.

18. Verfahren nach Anspruch 17, bei dem das Bad 0,1 bis 5 Gew.-% eines Komplexbildners für Kupfer enthält.

19. Verfahren nach Anspruch 17 oder 18, bei dem das Bad 0,001 bis 0,1 Gew.-% elektrisch leitfähiges Polymer enthält.

## Claims

1. A coated article, which contains
(i) at least one electrically non-conductive base layer,
(ii) at least one layer of copper and/or a copper alloy, and
(iii) a tin-containing layer,
wherein the layer (ii) is positioned between the layer (i) and the layer (iii), **characterized in that** the tin-containing layer (iii) contains at least silver as a further metal and at least one electrically conductive polymer, wherein the concentration of silver at the copper surface is lower than in the sublayer of the layer (iii) lying above this.

2. The coated article according to claim 1, wherein the layer (iii) contains a finely divided or multiphase mixture of tin and silver.

3. The coated article according to claim 2, wherein the metal particles or the metal phases have a size of 1 to 500 nm.

4. The coated article according to one of claims 1 to 3, wherein the layer (iii) additionally contains a complexing agent.

5. The coated article according to claim 4, wherein the complexing agent is capable of complex formation with copper.

6. The coated article according to claim 1, wherein the electrically conductive polymer is selected from the group of the polyanilines, polythiophenes, polypyrroles, and mixtures thereof.

7. The coated article according to one of claims 1 to 6, wherein the layer (iii) contains 1 ppb to 5 wt.% electrically conductive polymer.

8. The coated article according to one of the previous claims, wherein the layer (i) has a layer thickness of 0.1 to 3 mm.

9. The coated article according to one of the previous claims, wherein the layer (ii) has a layer thickness of 5 to 210 µm.

10. The coated article according to one of the previous claims, wherein the layer (iii) has a layer thickness of 50 nm to 4 µm.

11. The coated article according to one of the previous claims, wherein the tin concentration in the outer 300 nm to 3 µm of the layer (iii) is more than 50 mol.%.

12. The coated article according to one of the previous claims, wherein the concentration of silver in the upper 0.5 to 5% of the layer (iii) is lower than in the next 2 to 10%, and is higher there than in the 5 to 95% of the layer lying thereunder.

13. The coated article according to one of the previous claims in the form of a printed circuit board.

14. A process for the production of a coated article according to claims 1 to 13, wherein
(1) a layer of copper or of a copper-containing alloy is applied onto the surface of a base layer,
(2) the layer produced in step (1) is structured, and
(3) a tin-containing layer is applied onto the structured copper or copper alloy layer, wherein first a layer of silver as a further metal and an electrically conductive polymer is deposited onto the layer formed in step (2), wherein an open pore, porous surface is obtained, and then a tin layer is deposited onto the layer of the silver and the conductive polymer.

15. The process according to claim 14, wherein the layer of the silver and the conductive polymer is deposited in a thickness of 3 to 100 nm.

16. The process according to claim 14 or 15, wherein the tin is deposited in a layer thickness of 100 nm to 3 µm.

17. The process according to one of claims 14 to 15, wherein the layer of the silver and the conductive polymer is deposited from an aqueous bath which contains ions of the metal in a concentration of 0.003 to 1 wt.% and one or several organic additives each in a concentration of 0.001 to 25 wt.%.

18. The process according to claim 17, wherein the bath contains 0.1 to 5 wt.% of a complexing agent for copper.

19. The process according to claim 17 or 18, wherein the bath contains 0.001 to 0.1 wt.% of electrically conductive polymer.

## Revendications

1. Article revêtu, lequel contient
(i) au moins une couche de base non électroconductrice,
(ii) au moins une couche à base de cuivre et/ou d'un alliage de cuivre, et
(iii) une couche contenant de l'étain,
la couche (ii) étant disposée entre la couche (i) et la couche (iii), **caractérisé en ce que** la couche contenant de l'étain (iii) contient au moins de l'argent comme autre métal et au moins un polymère électroconducteur, la concentration de l'argent sur la surface limite du cuivre étant inférieure à la concentration dans la couche partielle sus-jacente de la couche (iii).

2. Article revêtu selon la revendication 1, sur lequel la couche (iii) contient un mélange à parties fines ou à plusieurs phases d'étain et d'argent.

3. Article revêtu selon la revendication 2, sur lequel les particules de métal ou les phases de métal présentent une grandeur de 1 jusqu'à 500 nm.

4. Article revêtu selon l'une quelconque des revendications 1 à 3, sur lequel la couche (iii) contient en supplément un agent complexant.

5. Article revêtu selon la revendication 4, sur lequel l'agent complexant est apte à la complexation avec du cuivre.

6. Article revêtu selon la revendication 1, sur lequel le polymère électroconducteur est sélectionné parmi le groupe des polyanilines, polythiophènes, polypyrrols et mélanges de ceux-ci.

7. Article revêtu selon l'une quelconque des revendications 1 à 6, sur lequel la couche (iii) contient 1 ppb jusqu'à 5 % en poids de polymère électroconducteur.

8. Article revêtu selon l'une quelconque des revendications précédentes, sur lequel la couche (i) présente une épaisseur de couche de 0,1 à 3 mm.

9. Article revêtu selon l'une quelconque des revendications précédentes, sur lequel la couche (ii) présente une épaisseur de 5 à 210 µm.

10. Article revêtu selon l'une quelconque des revendications précédentes, sur lequel la couche (iii) présente une épaisseur de 50 nm à 4 µm.

11. Article revêtu selon l'une quelconque des revendications précédentes, sur lequel la concentration d'étain dans les 300 nm jusqu'à 3 µm extérieurs de la couche (iii) est supérieure à 50 % de mole.

12. Article revêtu selon l'une quelconque des revendications précédentes, sur lequel la concentration de l'argent dans les 0,5 jusqu'à 5 % supérieurs de la couche (iii) est inférieure à la concentration dans les 2 à 10 % suivants, et là est supérieure à la concentration dans les 5 à 95 % sous-jacents de la couche.

13. Article revêtu selon l'une quelconque des revendications précédentes sous la forme d'une carte à circuits imprimés.

14. Procédé pour la fabrication d'un article revêtu selon les revendications 1 à 13, sur lequel
(1) on applique sur la surface d'une couche de base une couche à base de cuivre ou d'un alliage contenant du cuivre,
(2) on structure la couche fabriquée à l'étape (1) ; et
(3) on applique une couche contenant de l'étain sur la couche de cuivre ou la couche d'alliage de cuivre structurée, moyennant quoi on dépose d'abord une couche d'argent comme autre métal et un polymère électroconducteur sur la couche formée à l'étape (2), une surface poreuse et à pores ouverts se formant, et on dépose une couche d'étain sur la couche de l'argent et du polymère conducteur.

15. Procédé selon la revendication 14, dans lequel on dépose la couche de l'argent et du polymère conducteur dans une épaisseur de 3 à 100 nm.

16. Procédé selon la revendication 14 ou 15, dans lequel on dépose l'étain dans une épaisseur de couche de 100 nm jusqu'à 3 µm.

17. Procédé selon l'une quelconque des revendications 14 à 15, dans lequel on dépose la couche de l'argent et du polymère conducteur à partir d'un bain aqueux, qui contient des ions du métal dans une concentration de 0,003 jusqu'à 1 % en poids et un ou plusieurs additifs organiques dans une concentration de respectivement 0,001 jusqu'à 25 % en poids.

18. Procédé selon la revendication 17, dans lequel le bain contient 0,1 à 5 % en poids d'un agent complexant pour du cuivre.

19. Procédé selon la revendication 17 ou 18, dans lequel le bain contient 0,001 jusqu'à 0,1 % en poids de polymère électroconducteur.
